# EUROPEAN PATENT APPLICATION

(11) **EP 4 328 942 A1**
(43) Date of publication of application: **28.02.2024**
(21) Application number: 22306250.6
(22) Date of filing: 24.08.2022
(51) Int. Cl.: H01F 27/38, H01F 27/28, H01F 3/10, H02M 1/00, H02M 1/12, H02M 7/493

(54) **MULTIPHASE SYSTEM COMPRISING A POWER CONVERTER WITH THROUGH-OUTPUT COUPLED INDUCTORS, METHOD FOR PRODUCING THE SAME**

(71) Applicant: Mitsubishi Electric R & D Centre Europe B.V., 1119 NS Schiphol Rijk (NL); MITSUBISHI ELECTRIC CORPORATION, Chiyoda-ku Tokyo 100-8310 (JP)
(72) Inventor: LEFEVRE, Guillaume, 35700 RENNES (FR); MORAND, Julien, 35700 RENNES (FR)
(74) Representative: Cabinet Le Guen Maillet

(57) **Abstract**

The present invention concerns a multiphase system comprising a power converter having at least two legs and a filtering device connected to the at least two legs of the power converter, the filtering device being composed of at least two inductors, each inductor being composed of turns wounded around a magnetic material. The magnetic material is disposed within at least one printed circuit board that comprises connections of the inductors and the filtering device further comprises a conductive material surrounding the at least two inductors, a first terminal of each inductor being respectively connected to one leg of the power converter and one terminal of the conductive material is connected to the second terminals of the inductors.

## Description

### TECHNICAL FIELD

The present invention relates generally to through-output coupled inductors.

### RELATED ART

Recent advances of semiconductors technology, in particular wide band gap devices (WBG), have opened the field to more compact power electronic systems. Led by better dynamic performances of WBG switches compared to their Silicon counterpart, power converters can now be operated with much higher switching frequencies. This directly comes along alleviated constraints on both inductive and capacitive filtering devices. In conjunction with power converters interleaving techniques that are commonly used for high current applications, the volume and weight of magnetics components has been significantly reduced in the past years. Interleaved structures are composed of parallel cells also named legs. The drive signal of each leg is phase shifted. In particular, the phase shift can be evenly distributed according to the number of legs. If this condition is fulfilled, this structure allows to reduce the output current ripple by a factor of N² (N being the number of legs) due to an apparent frequency of N.Fsw (Fsw being the switching frequency of the power converter) and a HF voltage fictitiously divided by N. This allows to reduce the current rating on the semiconductors by distributing the design constraints over the devices. In interleaved converters with filtered output voltage, the filtering devices represent an important part of the converter weight. Classical solution is to use independent inductors, but such solution imposes an important weight and the magnetic device conception is crucial.

Meanwhile, since no significant improvement has been observed with regards to the magnetic materials, the designer has no other choice than defining the best trade-off between saturation field and core losses.

Conventional inductors involve a DC (Direct current) or LF (low frequency) field component superimposed to a HF (High Frequency) component. Magnetic saturation is the most critical point to address when targeting smaller inductors. It is also obvious that DC/LF and HF magnetic field can be treated independently since the HF induction field B_{HF} evolves irrespective of the magnetic permeability which is not the case of the low frequency or DC induction field B_{DC/LF}.

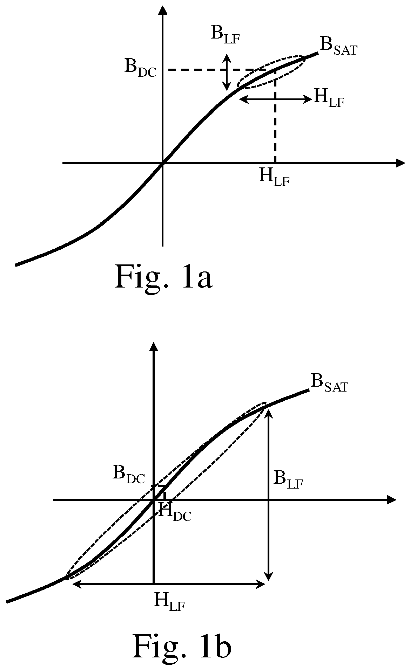

In the example given in Fig. 1a, the magnetization curve of an inductor may lead to a saturation of the induction field.

In Fig. la, B_{LF} stands for LF induction field, B_{DC} stands for DC induction field, H_{LF} stands for LF magnetic field and H_{DC} stands for DC magnetic field.

Based on these observations, compensate the LF/DC flux and operate the inductors in two magnetic quadrants is the best option as shown in Fig. 1b. By doing so, the saturation constraints related to the LF/DC field are alleviated which means that the inductor is now designed as a transformer with almost only HF components. One advantage of this solution is to fully decouple the design inductor (apart from the copper losses) from the current flowing through the device. Such demagnetization approach can be performed by magnetically coupling at least two inductors with a similar current flowing through.

It is then possible to achieve a reduction of the LF/DC magnetic field by adjusting the coupling factor between the at least two inductors. A very good coupling comes along a reduced B_{LF/DC} value but also a significant increase of the current ripple at N·F_{SW}. Indeed, the leakage inductance is the filtering device in charge of filtering the current harmonic at N·F_{SW} flowing in all the legs and a minimum value is mandatory to avoid generating HF losses that may lead to an unacceptable loss level and potentially the breakdown of the filtering device.

### SUMMARY OF THE INVENTION

The present invention aims to provide a filtering device in an interleaved structure of a converter composed of through-output coupled inductors that are designed using PCB based technologies.

Basically, each inductor is wound as a solenoid with the turns located in the longer dimension of the device. Several layers of conductors can be considered according to the inductive requirements, the targeted AC resistance and the overall capacitive behaviour. The windings of the multiple so-called solenoids lay over a single substrate. Both the substrate and the windings act as a frame to embed a first part of the magnetic circuit of each inductor. The coupling with the output current is performed through compensation turns done by foils made of conductive material.

Optionally, two plates made of magnetic materials are implemented at the top and the bottom to close the unitary magnetic paths.

To that end, the present invention concerns a multiphase system comprising a power converter having at least two legs and a filtering device connected to the at least two legs of the power converter, the filtering device being composed of at least two inductors, each inductor being composed of turns wounded around a magnetic material, characterized in that the magnetic material is disposed within at least one printed circuit board that comprises connections of the inductors and the filtering device further comprises a conductive material surrounding the at least two inductors, a first terminal of each inductor being respectively connected to one leg of the power converter and one terminal of the conductive material is connected to the second terminals of the inductors.

Thus, in this configuration, the two inductors are magnetically coupled through the conductive material for multiple frequencies of N·F_{SW}, N being the number of legs, and uncoupled for other frequencies and provide then an efficient filtering.

According to a particular feature, the filtering device comprises one printed circuit board having at least two cavities wherein each of the at least two magnetic materials is respectively placed.

Thus, the printed board acts as a frame for assembling and mechanically maintains the filtering device and embeds the magnetic cores. This frame can be consequently used in a lamination process if additional layers would be needed in the aforementioned printed circuit board.

According to a particular feature, the printed circuit board further comprises for each cavity, two spaces for wounding the inductors around the magnetic core.

Thus, the printed circuit board also acts as a yoke for inductors without any prerequisite on the winding technique but requiring wounding directly on the printed circuit board.

According to a particular feature, the printed circuit board further comprises for each cavity, two spaces for inserting the wounded inductors around the magnetic core.

Thus, according to this feature, the windings can be manufactured apart and mounted on the printed board by inserting through the spaces. This makes possible the use of a dedicated manufacturer for designing the windings without requiring the printed circuit board, leading to a more versatile process.

According to a particular feature, the filtering device comprises a first, a second and a third printed circuit boards, the third printed circuit board having at least two cavities wherein each of the at least two magnetic materials is respectively placed, the first and the second printed circuit boards having conductors, the conductors of the first and the second printed circuit boards being electrically connected and form windings of the inductors.

Thus, the design can benefit from the cost effective and streamlined PCB process. Also, additional features such as PCB embedded sensors could be implemented in conjunction to the windings on the printed circuit boards.

According to a particular feature, the conductive material surrounding the at least two inductors has a U shape.

Thus, this part could be easily manufactured. Also, the input and output of this conductor would be located on the same side (opposite side of the U bended part) which simplifies the overall mechanical design and the required interconnections.

According to a particular feature, the filtering device is surrounded by magnetic elements.

The present invention also concerns a method for manufacturing a multiphase system comprising a power converter having at least two legs and a filtering device connected to the at least two legs of the power converter, the filtering device being composed of at least two inductors, characterized in that the method comprises the steps of:
- disposing magnetic materials within at least one printed circuit board that comprises connections of the inductors,
- disposing, for each inductor, turns wounded around the magnetic material,
- placing a conductive material surrounding the at least two inductors,
- connecting the filtering device by connecting respectively a first terminal of each inductor to one leg of the power converter and connecting one terminal of the conductive material to the second terminals of the inductors.

### BRIEF DESCRIPTION OF THE DRAWINGS

The characteristics of the invention will emerge more clearly from a reading of the following description of example embodiments, the said description being produced with reference to the accompanying drawings, among which:
Fig. la represents a magnetization curve of a filtering device in an interleaved structure of a converter;
Fig. 1b represents a magnetization curve of a filtering device in an interleaved structure of a converter comprising through-output coupled inductors according to the present invention;
Fig. 2 represents an example of realization of an interleaved structure of a converter comprising a filtering device composed of through-output coupled inductors according to the present invention;
Fig. 3 represents a more detailed example of realization of the interleaved structure of a converter comprising a filtering device composed of through-output coupled inductors according to the present invention;
Fig. 4 represents a first example of realization of two inductors of a filtering device that are realized using a printed circuit board;
Fig. 5 represents a second example of realization of an inductor of a filtering device that is realized using printed circuit boards;
Fig. 6 represents a first example of a through-output coupled inductors according to the invention;
Fig. 7 represents an architecture of a system for making a filtering device in an interleaved structure of a converter comprising through-output coupled inductors;
Fig. 8 represents an algorithm for making a filtering device in an interleaved structure of a converter comprising through-output coupled inductors.

### DESCRIPTION

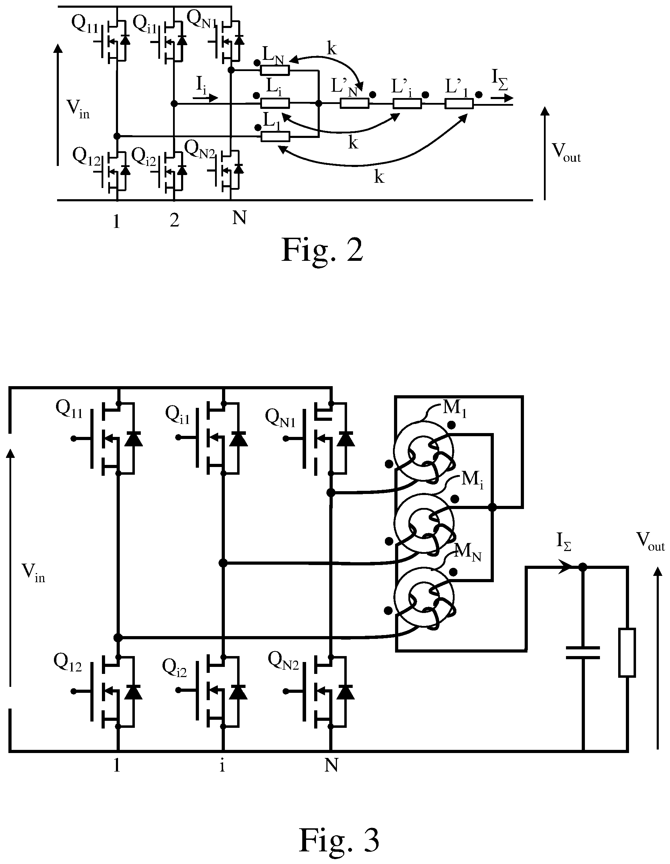

**Fig. 2** represents an example of realization of an interleaved structure of a converter comprising a filtering device according to the present invention.

In the example of Fig. 2, the converter comprises N legs. The switches Q₁₁ and Q₁₂ are switches of the first leg 1 and are connected to a first terminal of an inductor Li.

The switches Qᵢ₁ and Qᵢ₂ are switches of the i-th leg i and are connected to a first terminal of an inductor Li. The switches Q_{N1} and Q_{N2} are switches of the N-th leg N and are connected to a first terminal of an inductor L_{N}.

The second terminals of the inductors L₁, Li and L_{N} are connected to a first terminal of an inductor L'_{N}, the second terminal of the inductor L'_{N} is connected to a first terminal of an inductor L'i and the second terminal of the inductor L'i is connected to a first terminal of an inductor L'₁. As shown in Fig. 2, the inductors L₁ and L'₁ are magnetically coupled, the inductors Lᵢ and L'ᵢ are magnetically coupled and the inductors L_{N} and L'_{N} are magnetically coupled.

Each magnetic device, here labelled Lᵢ, is coupled to another magnetic device L'i through which flows the output current I_{Σ}.

As the magnetic devices are coupled, this theoretically results in an indirect magnetic coupling between the Li inductors, vias the L'i. With this arrangement, only the coupling between one phase and the output conductor has to be managed, adding degree of freedom in the design or release the constraints on the layout of the magnetic part. By doing so, the LF/DC magnetic flux can be cancelled or partially compensated depending on the turn ratio.

More precisely, as shown in Fig. 3, the inductors L₁ and L'₁ are magnetically coupled with a magnetic material M₁, the inductors Lᵢ and L'ᵢ are magnetically coupled with a magnetic material Mi and the inductors L_{N} and L'_{N} are magnetically coupled with a magnetic material M_{N}. The magnetic materials M₁ to M_{N} are implemented with a toroidal core geometry made with a magnetic material such a ferrite, nanocristallyne or iron powder according to the required level of losses.

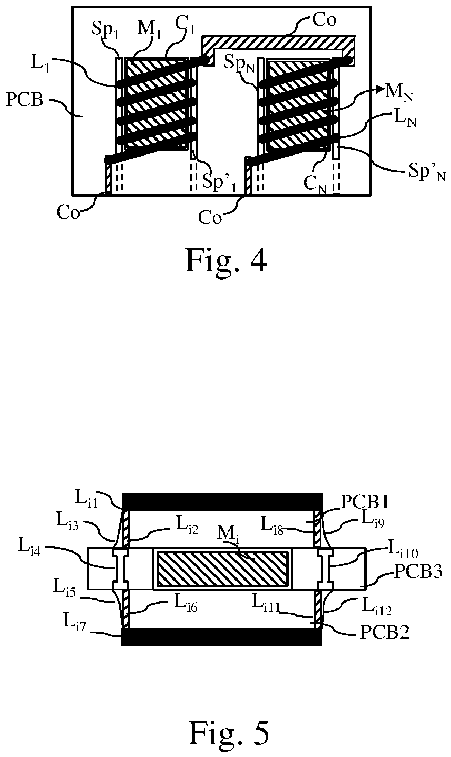

Fig. 4 represents a first example of realization of two inductors of a filtering device that are realized using a printed circuit board.

In the example of Fig. 4, each inductor L₁ or L_{N} is wound as a solenoid with the turns located in the longer dimension of the filtering device. The terminals of the inductors L₁ or L_{N} have electrical connections Co that are for example parts of a copper layer of a printed circuit board PCB.

For each inductor L₁ or L_{N}, the printed circuit board comprises a cavity in which the magnetic material M₁ or M_{N} is placed. Several layers of conductors can be considered according to the inductive requirements, the targeted AC resistance, and the overall capacitive behaviour. The wires composing the inductor L₁ or L_{N} are represented in the example of Fig. 4 by bold black lines and are wounded around the magnetic materials. The wounded inductors and the magnetic materials are placed in the respective cavities C₁ and C_{N} of the printed circuit board. In a variant, the magnetic materials are placed in the respective cavities C₁ and C_{N} and the inductors L₁ or L_{N} are wounded around the magnetic material thanks to spaces Sp₁, Sp_{N} Sp'₁ and Sp'_{N} that are prolongated by apertures shown in Fig. 4 with dotted lines.

Both the PCB and the windings act as a frame to embed magnetic materials Mi or M_{N}.

**Fig. 5** represents a second example of realization of an inductor of a filtering device that is realized using printed circuit boards.

In the example of Fig. 5, the inductor Li is represented. The inductor Li is realized using plural printed circuit boards PCB 1, PCB2 and PCB3.

The printed circuit PCB3 comprises a cavity wherein the magnetic material Mi is placed.

The printed circuit board PCB1 comprises an insulation layer on which a conductive layer is disposed and is a castellated board or comprises flex terminals.

The printed circuit board PCB2 comprises an insulation layer on which a conductive layer is disposed and is a castellated board or comprises flex terminals.

The insulation layer of the printed circuit board PCB2 is disposed on the bottom of the printed circuit PCB3 and the insulation layer of the printed circuit board PCB1 is disposed on the top of the printed circuit PCB3.

The inductor Lᵢ is made of the conductive layer Lᵢ₁, flex terminals or castellation Lᵢ₂ and Lᵢ₈ of the printed circuit board PCB 1, soldering Lᵢ₃ and Li₉, vias Lᵢ₄ and Lᵢ₁₀ of the printed circuit board PCB3, the conductive layer Li₇, flex terminals or castellations Lᵢ₆ and Lᵢ₁₁ of the printed circuit board PCB 1 and soldering Lᵢ₅ and Lᵢ₁₂.

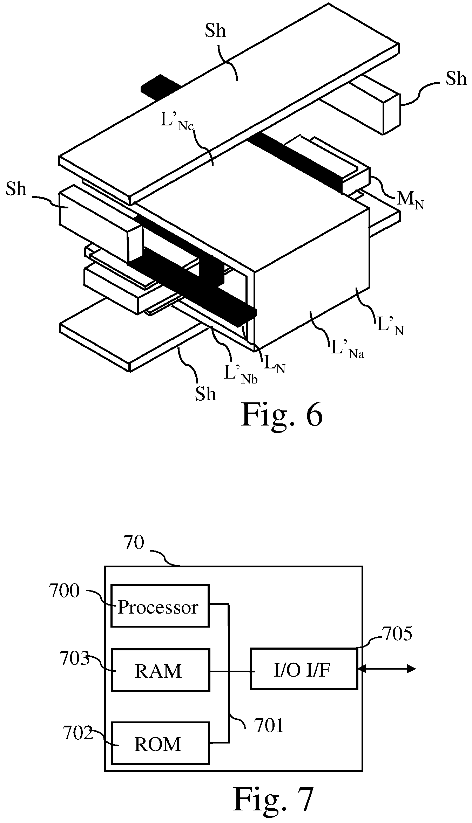

**Fig. 6** represents through-output coupled inductors according to the invention.

According to the invention, compensation turn L'_{N} is achieved with conductive foils (copper or aluminium). This single conductor is designed to be implemented to compensate the LF magnetic field in each unitary inductor. In a possible implementation, the compensation turn L'_{N} is U-shaped made of parts L'_{Na}, L'_{Nb} and L'_{Nc}, which corresponds to a single compensation turn. In a multi-compensation turn configuration, the windings can be either designed with concentric foils or a metallic piece folded to obtain a solenoid-like geometry. The choice of either solution depends on the rated current and targeted AC resistor value. Whatever the selected geometry, compensation turns L'_{N} will be located over the main turn L_{N} to be coupled.

In a possible implementation, the compensation turn L'₁ or L'i is only composed of parts L'_{Nb} and L'_{Nc}.

Finally, the magnetic paths are closed with a top, sides and a bottom magnetic plates Sh. For example, magnetic plates Sh is composed of two C shape plates, or a C and I shape magnetic plates

**Fig. 7** represents an architecture of a system for making a filtering device in an interleaved structure of a converter comprising through-output coupled inductors.

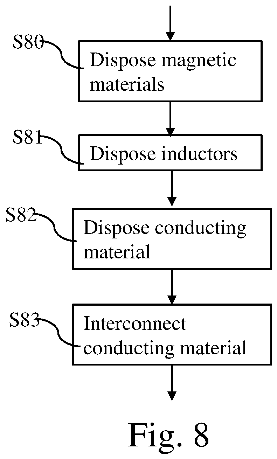

The system 70 has, for example, an architecture based on components connected by a bus 801 and a processor 800 controlled by a program as disclosed in Fig. 8.

The bus 701 links the processor 700 to a read only memory ROM 702, a random access memory RAM 703, an input output I/O IF interface 705.

The input output I/O IF interface 705 enables the control of the different apparatus that are used to produce filtering devices comprising through-output coupled inductors.

The memory 703 contains registers intended to receive variables and the instructions of the program related to the algorithm as disclosed in Fig. 8.

The read-only memory, or possibly a Flash memory 702, contains instructions of the programs related to the algorithm as disclosed in Fig. 8, when the system 70 is powered on, that are loaded to the random access memory 703. Alternatively, the program may also be executed directly from the ROM memory 702.

The system 70 may be implemented in software by execution of a set of instructions or program by a programmable computing machine, such as a PC (*Personal Computer*), a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit*).

In other words, the system 70 includes circuitry, or a device including circuitry, causing the system 70 to perform the program related to the algorithm as disclosed in Fig. 8.

**Fig. 8** represents an algorithm for making a filtering device in an interleaved structure of a converter comprising through-output coupled inductors.

The present algorithm discloses a method for manufacturing a multiphase system comprising a power converter having at least two legs and a filtering device connected to the at least two legs of the power converter.
At step S80, magnetic materials are disposed within at least one printed circuit board that comprises connections of the inductors.
At step S81, turns of each inductor are wounded around the magnetic materials.
In a variant of realization, turns of each inductor are wounded around the magnetic materials and are disposed within at least one printed circuit board that comprises connections of the inductors.
At step S82, a conductive material surrounding the at least two inductors is placed. At step S83, the filtering device is connected by connecting respectively a first terminal of each inductor to one leg of the power converter and connecting one terminal of the conductive to the second terminals of the inductors.

Naturally, many modifications can be made to the embodiments of the invention described above without departing from the scope of the present invention.

## Claims

1. A multiphase system comprising a power converter having at least two legs and a filtering device connected to the at least two legs of the power converter, the filtering device being composed of at least two inductors, each inductor being composed of turns wounded around a magnetic material, **characterized in that** the magnetic material is disposed within at least one printed circuit board that comprises connections of the inductors and the filtering device further comprises a conductive material surrounding the at least two inductors, a first terminal of each inductor being respectively connected to one leg of the power converter and one terminal of the conductive material is connected to the second terminals of the inductors.

2. The multiphase system according to claim 1, **characterized in that** the filtering device comprises one printed circuit board having at least two cavities wherein each of the at least two magnetic materials is respectively placed.

3. The multiphase system according to claim 2, **characterized in that** the printed circuit board further comprises for each cavity, two spaces for wounding the inductors around the magnetic core.

4. The multiphase system according to claim 2, **characterized in that** the printed circuit board further comprises for each cavity, two spaces for inserting the wounded inductors around the magnetic core and the magnetic core.

5. The multiphase system according to claim 1, **characterized in that** the filtering device comprises a first, a second and a third printed circuit boards, the third printed circuit board having at least two cavities wherein each of the at least two magnetic materials is respectively placed, the first and the second printed circuit boards having conductors, the conductors of the first and the second printed circuit boards being electrically connected and form windings of the inductors.

6. The multiphase system according to claim 5, **characterized in that** the conductive material surrounding the at least two inductors has a U shape.
According to a particular feature, the filtering device is surrounded by magnetic elements.

7. A method for manufacturing a multiphase system comprising a power converter having at least two legs and a filtering device connected to the at least two legs of the power converter, the filtering device being composed of at least two inductors, **characterized in that** the method comprises the steps of:
- disposing magnetic materials within at least one printed circuit board that comprises connections of the inductors,
- disposing, for each inductor, turns wounded around the magnetic material,
- placing a conductive material surrounding the at least two inductors,
- connecting the filtering device by connecting respectively a first terminal of each inductor to one leg of the power converter and connecting one terminal of the conductive material to the second terminals of the inductors.
